# EUROPÄISCHE PATENTSCHRIFT

(11) **EP 2 277 203 B1**
(45) Veröffentlichungstag und Bekanntmachung des Hinweises auf die Patenterteilung: **07.03.2012**
(21) Anmeldenummer: 09733502.0
(22) Anmeldetag: 09.04.2009
(51) Int. Cl.: H01L 31/0216, H01L 31/0224, H01L 21/225, H01L 31/068, H01L 31/18

(54) **VERFAHREN ZUR SELEKTIVEN DOTIERUNG VON SILIZIUM**
METHOD FOR THE SELECTIVE DOPING OF SILICON
PROCÉDÉ DE DOPAGE SÉLECTIF DE SILICIUM

(30) Priorität: 14.04.2008 DE 102008019402
(43) Veröffentlichungstag der Anmeldung: 26.01.2011
(73) Patentinhaber: Gebr. Schmid GmbH, 72250 Freudenstadt (DE)
(72) Erfinder: HABERMANN, Dirk, 79199 Kirchzarten (DE)
(74) Vertreter: Patentanwälte Ruff, Wilhelm, Beier, Dauster & Partner
(86) Internationale Anmeldenummer: PCT/EP2009/002671
(87) Internationale Veröffentlichungsnummer: WO 2009/127369

(56) Entgegenhaltungen:
- EP-A- 1 775 759
- EP-A- 1 804 299
- EP-A- 1 876 650
- EP-A- 1 876 651
- WO-A-97/13280
- DE-A1- 1 444 520
- DE-A1- 2 856 797
- DE-A1- 4 217 428
- DE-A1- 19 534 574
- DE-A1-102006 003 283
- GB-A- 2 010 012
- JP-A- 2000 183 379
- JP-A- 2004 281 569
- US-A- 4 070 689
- US-A- 4 758 525
- US-A1- 2007 151 598

## Beschreibung

### Anwendungsgebiete und Stand der Technik

Die Erfindung betrifft ein Verfahren zur selektiven Dotierung von Silizium eines Silizium-Substrats, um einen pn-Übergang im Silizium herzustellen. Dieses Verfahren wird beispielsweise bei der Herstellung von Solarzellen benötigt.

Die selektive Dotierung des Emitters von Silizium zur Herstellung eines pn-Übergangs in Silizium wird zur Verbesserung der Kontaktierung und Leitungseigenschaften in der Solartechnologie eingesetzt. Mit diesem Prozess kann die Effizienz von Solarzellen gesteigert werden. Zur Herstellung selektiver Emitter werden bisher Lasertechnologien eingesetzt, bei denen das Dotiermedium durch einen hochenergetischen Laserstrahl in das Silizium diffundiert. Andere Verfahren basieren auf der Plasma-Ätzung von hoch dotierten Emittern. Die Bereiche, bei denen die hohe Dotierung erhalten bleiben soll, werden zuvor maskiert.

Ein Beispiel für weitere Verfahren ist die US 5,871,591, bei denen grundsätzlich die Bereiche meist lithographisch maskiert werden, bei denen die zu Beginn hohe Dotierung nach dem Ätzen erhalten bleiben soll. Diese Verfahren entfernen somit eine dünne, meist 100-200 nm dicke Schicht mit oberflächennaher hoher Dotierung, um eine selektive Emitterverteilung zu erhalten. Nachteil dieser Verfahren ist jedoch, dass die Ätzung der Oberfläche sehr präzise erfolgen muss, um nicht einen deutlichen Verlust in der Effizienz der Solarzellen zu bewirken. Bei lasergestützten Technologien besteht ebenfalls die Gefahr einer starken Beschädigung der Solarzellenoberfläche, weshalb auch diese Technologie nur sehr vereinzelt in der Solartechnologie eingesetzt wird.

Die JP 2004-281569 A beschreibt ein Verfahren zur selektiven Dotierung von Silizium eines Silizium-Substrats, wobei eine zweite Dotierung selektiv aufgebracht wird und eine Eindiffundierung erfolgt.

Die DE 1444520 A1 beschreibt ein Verfahren, bei dem beim selektiven Dotieren bestimmte Bereiche durch eine Maskierung abgedeckt werden.

### Aufgabe und Lösung

Der Erfindung liegt die Aufgabe zu Grunde, ein eingangs genanntes Verfahren zu schaffen, mit denen Probleme des Standes der Technik beseitigt werden können und insbesondere ein effizientes und gut durchführbares Verfahren zur selektiven Dotierung eines Silizium-Substrats erreicht werden kann.

Gelöst wird diese Aufgabe durch ein Verfahren mit den Merkmalen des Anspruchs 1. Vorteilhafte sowie bevorzugte Ausgestaltungen der Erfindung sind in den weiteren Ansprüchen angegeben und werden im Folgenden näher erläutert. Der Wortlaut der Ansprüche wird durch ausdrückliche Bezugnahme zum Inhalt der Beschreibung gemacht. Des weiteren wird der Wortlaut der Prioritätsanmeldung DE 102008019402.6 vom 14. April 2008 derselben Anmelderin durch ausdrückliche Bezugnahme zum Inhalt der vorliegenden Beschreibung gemacht.

Das Verfahren weist erfindungsgemäß folgende Schritte auf. In einem Schritt a) wird die Oberfläche des Siliziums bzw. des Silizium-Substrats mit einem Dotiermittel belegt, welches auf Phosphor basiert bzw. Phosphor enthält. Beispielsweise ist dies eine Lösung aus Phosphorsäure. In einem Schritt b) danach wird das Silizium-Substrat erhitzt bzw. das Dotiermittel, um auf der Oberfläche aus dem Dotiermittel Phosphor-Silikatglas zu erzeugen. Dabei wird gleichzeitig als erste Dotierung des Silizium-Substrats Phosphor in das Silizium hinein diffundiert. Die Stärke dieser Dotierung kann durch Dauer und Temperatur des Erhitzens eingestellt werden.

In einem folgenden Schritt c) wird eine Maskierung auf das Phosphor-Silikatglas auf der Oberfläche des Silizium-Substrats aufgebracht. Die Maskierung wird dabei so aufgebracht, dass sie die später hochdotierten Bereiche des Silizium-Substrats bedeckt. In einem folgenden Schritt d) wird das Phosphor-Silikatglas in den nicht maskierten Bereichen entfernt. Danach wiederum wird in einem Schritt e) die Maskierung von der Oberfläche bzw. dem Phosphor-Silikatglas entfernt. In einem folgenden Schritt f) wird das Silizium-Substrat erneut erhitzt, um ein weiteres Eindiffundieren von Phosphor aus dem verbliebenen Phosphor-Silikatglas in das Silizium zu bewirken. Dies ist die zweite Dotierung des Silizium-Substrats, um die hoch dotierten Bereiche zu erzeugen. In den Bereichen, die frei sind von Phosphor-Silikatglas, dient lediglich die vergleichsweise geringe oberflächennahe Phosphordotierung als sekundäre Dotierquelle für die tiefere Diffusion von Phosphor in das Basismaterial. In einem weiteren Schritt g) werden auch das restliche Phosphor-Silikatglas und das Oxid auf den schwach dotierten Bereichen vollständig von dem Silizium-Substrat entfernt. Auf diese Weise wird nicht nur allgemein eine selektive Dotierung eines Silizium-Substrats geschaffen mit hoch dotierten Bereichen, die Emitter einer Solarzelle bilden können. Es kann vor allem auch ein Verfahren geschaffen werden, welches in großem Maßstab eine taugliche Produktion bzw. Bearbeitung von Silizium-Substraten schafft. Vor allem kann das Verfahren in einer Durchlaufanlage durchgeführt werden. Aufwendige Technologie wie Laser oder Plasma-Ätzquellen können entfallen.

In einer weiteren Ausgestaltung des erfindungsgemäßen Verfahrens kann das auf Phosphor basierende Dotiermittel eine Lösung sein, die Phosphorsäure enthält.

Zur Aufbringung der Maskierung auf das Silizium-Substrat bzw. das darauf gebildete Phosphorsilikatglas kann eine Drucktechnologie verwendet werden. Entweder kann dies über Siebdruck erfolgen oder aber über sogenannte Inkjet-Drucktechnologie. Dabei wird die Maskierung, die beispielsweise aus einem Wachs oder Lack besteht, in flüssiger oder pastöser Form aufgebracht mit einem Verfahren, welches dem in sogenannten Tintenstrahldruckern verwendeten entspricht. Dadurch kann sowohl sehr genau als auch schnell und großflächig eine gewünschte Maskierung erzeugt werden. Mit diesem Verfahren kann beispielsweise als hoch dotierter bzw. leitfähiger Emitter ein Kontakt-Grid hergestellt werden, wobei die Solarzelle von dem Silizium-Substrat gebildet wird. Durch die zweifache Dotierung des Siliziums entstehen die hoch dotierten Bereiche. Vor allem kann in dem Schritt f) der zweiten Dotierung durch eine längere Einwirkdauer bzw. ein längeres Erhitzen die Dotierung noch einmal stärker erfolgen. Somit kann in dem hoch dotierten Bereich die Dotierung vielfach höher sein als in den sonstigen, geringer dotierten Bereichen.

Um das Phosphor-Silikatglas in den nicht maskierten Bereichen gemäß Schritt c) zu entfernen, kann ein Ätzprozess verwendet werden. Hier bieten sich beispielsweise HF-basierende Ätzlösungen an, jedoch sind auch andere Ätzmedien möglich. Dies kann sowohl in einem Prozessschritt als auch in mehreren Schritten mit unterschiedlichen Chemikalien erfolgen.

Eine Durchlaufanlage zur Durchführung des Verfahrens kann aus mehreren Modulen bestehen. Dabei können in einem Modul eventuell auch mehrere der Schritte durchgeführt werden. Besonders bevorzugt wird eine Horizontal-Durchlaufanlage, auf der die Silizium-Substrate liegend befördert und behandelt werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

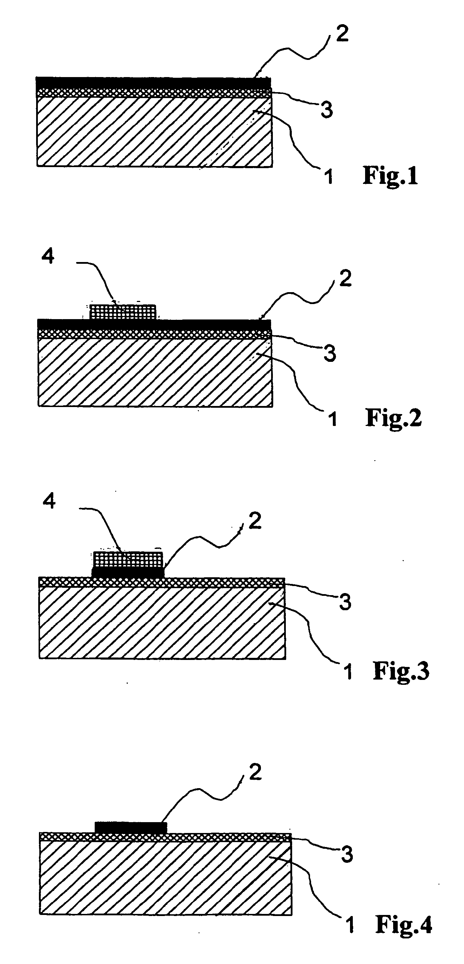

Ein Ausführungsbeispiel der Erfindung ist in den Zeichnungen schematisch dargestellt und wird im Folgenden näher erläutert. In den Zeichnungen zeigen die Fig. 1 bis 6 die Verfahrensschritte a) bis g) an einem Silizium-Substrat zur Herstellung einer Solarzelle.

### Detaillierte Beschreibung des Ausführungsbeispiels

In Fig. 1 ist ein Silizium-Substrat 1 dargestellt, auf welches gemäß Schritt a) sowie Schritt b) ein Dotiermittel großflächig aufgebracht worden ist. Dieses Dotiermittel 2 enthält Phosphor bzw. basiert auf Phosphor und ist beispielsweise eine Lösung aus Phosphorsäure. Des Weiteren ist durch Aufheizen auf nicht näher dargestellte Art und Weise, beispielsweise durch Heizstrahler odgl., Phosphor aus dem Dotiermittel 2 in das Silizium-Substrat 1 bzw. dessen Oberseite eindiffundiert. Dadurch ist ein niedrig dotierter Bereich 3 entstanden, was durch die Kreuzschraffur verdeutlicht wird.

In der Fig. 2 ist dargestellt, wie gemäß Schritt c) eine Maskierung 4 auf die Oberseite des Dotiermittels 2 aufgebracht ist. Diese Maskierung 4 wird auf vorbeschriebene Art und Weise durch eine Inkjet-Drucktechnologie aufgebracht und verläuft vorteilhaft großteils in den dargestellten, schmalen Bahnen, wobei jedoch auch andere Maskierungsmuster möglich sind. Diese Bahnen der Maskierung 4 entsprechen den gewünschten hochdotierten Bereichen, auf die nachfolgend noch genauer eingegangen wird.

In Fig. 3 ist dargestellt, wie gemäß Schritt d) das Dotiermittel 2, welches nach dem Aufheizen gemäß Fig. 1 und Schritt b) in Phosphor-Silikatglas umgewandelt worden ist, überall dort entfernt worden ist, wo es nicht von der Maskierung 4 überdeckt wird. Somit liegt im Wesentlichen die Oberfläche des niedrig dotierten Bereichs 3 des Silizium-Substrats 1 frei. Unter der Maskierung 4 sind entsprechend ausgebildete Bereiche des Phosphor-Silikatglases 2 noch vorhanden.

Gemäß Schritt e) wird, wie in Fig. 4 dargestellt ist, anschließend die Maskierung 4 entfernt. Während im Schritt d) gemäß Fig. 3 das Phosphor-Silikatglas durch HF-Ätzen entfernt werden kann, reicht zum Entfernen der Maskierung 4 eine weitaus weniger aggressive Lösung.

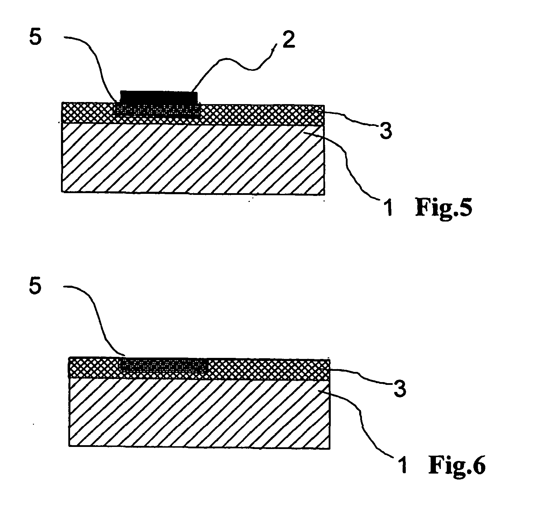

In Fig. 5 ist dargestellt, wie gemäß Schritt f) durch erneutes Erhitzen aus dem nun freiliegenden Phosphor-Silikatglas 2 mit einer Form entsprechend der aufgebrachten und wieder entfernten Maskierung 4 erneut Phosphor in das Silizium-Substrat 1 eindiffundiert. Der Phosphor aus dem Phosphor-Silikatglas 2 bildet einen schmalen Bereich mit einer Form entsprechend dem Phosphor-Silikatglas 2 gemäß Fig. 4 bzw. der Maskierung 4 gemäß Fig. 2. Auch im Übrigen wird in dem niedrig dotierten Bereich 3 des Silizium-Substrats 1, also im Wesentlichen vollflächig, Phosphor aus dem oberflächennahen Bereich noch etwas tiefer in das Silizium-Substrat 1 hinein diffundiert, als es nach dem ersten Diffusionsschritt der Fall ist. Im niedrig dotierten Bereich 3 und im hoch dotierten Bereich 5 nimmt die Phosphorkonzentration von der Oberfläche ins Basismaterial hinein ab, wobei sich die Dotierungstiefe durchaus unterscheiden kann.

Gemäß Schritt g) wird, wie in Fig. 6 dargestellt ist, auch das restliche Phosphor-Silikatglas 2 entfernt, vorteilhaft wiederum durch HF-Ätzen. Bei diesem Schritt wird ebenfalls eine dünne Schicht mit einem Oxid im schwach dotierten Bereich entfernt. Dann liegt das Silizium-Substrat 1 gemäß Fig. 6 vor mit einem vollflächig niedrig dotierten Bereich 3. In diesem niedrig dotierten Bereich 3 verlaufen die hoch dotierten Bereiche 5 und bilden bei einer Solarzelle den niederohmigen Emitter bzw. ein sogenanntes Kontakt-Grid.

Durch die Erfindung kann mit technologisch gut beherrschbaren Verfahren, die sämtlich im Durchlauf durchgeführt werden können, ein selektives Dotieren eines Silizium-Substrats erfolgen. So kann beispielsweise, wie beschrieben, ein Kontakt-Grid für eine Solarzelle hergestellt werden.

## Patentansprüche

1. Verfahren zur selektiven Dotierung von Silizium eines Silizium-Substrats (1) zur Herstellung eines pn-Übergangs im Silizium, mit folgenden Schritten:
a) Belegen der Oberfläche des Silizium-Substrats (1) mit einem auf Phosphor basierenden Dotiermittel (2),
b) anschließendes Erhitzen des Silizium-Substrats (1) zur Erzeugung eines Phosphor-Silikatglases (2) auf der Oberfläche des Siliziums, wobei gleichzeitig Phosphor in das Silizium hinein diffundiert als erste Dotierung (3),
c) Aufbringen einer Maskierung (4) auf das Phosphor-Silikatglas (2) derart, dass die Maskierung (4) die später hochdotierten Bereiche (5) bedeckt,
d) Entfernen des Phosphor-Silikatglases (2) in den nicht maskierten Bereichen,
e) Entfernen der Maskierung (4) von dem Phosphor-Silikatglas (2),
f) erneutes Erhitzen zum weiteren Eindiffundieren von Phosphor aus dem Phosphor-Silikatglas (2) in das Silizium als zweite Dotierung zur Erzeugung der hochdotierten Bereiche (5),
g) vollständiges Entfernen des Phosphor-Silikatglases (2) bzw. des Oxides von dem Silizium-Substrat (1).

2. Verfahren nach Anspruch 1, **dadurch gekennzeichnet, dass** das auf Phosphor basierende Dotiermittel (2) eine Lösung mit Phosphorsäure ist.

3. Verfahren nach Anspruch 1 oder 2, **dadurch gekennzeichnet, dass** die Maskierung (4) mit einer Drucktechnologie, vorzugsweise einer sogenannten Inkjet-Drucktechnologie, aufgebracht wird.

4. Verfahren nach einem der vorhergehenden Ansprüche, **dadurch gekennzeichnet, dass** damit ein Kontakt-Grid einer Solarzelle hergestellt wird, wobei das Silizium-Substrat (1) die Solarzelle bildet, wobei die zweimal dotierten Bereiche (5) des Siliziums hochdotiert sind und deswegen niederohmig sind und einen Kontaktbereich der Solarzelle darstellen.

5. Verfahren nach einem der vorhergehenden Ansprüche, **dadurch gekennzeichnet, dass** das Entfernen des Phosphor-Silikatglases (2) in den nicht maskierten Bereichen gemäß Schritt d) durch Ätzen erfolgt, vorzugsweise HF-Ätzen.

6. Verfahren nach einem der vorhergehenden Ansprüche, **dadurch gekennzeichnet, dass** es in einer Durchlaufanlage durchgeführt wird, vorzugsweise in einer Horizontal- Durchlaufanlage.

## Claims

1. Method for the selective doping of silicon of a silicon substrate (1) for the production of a pn junction in the silicon, comprising the following steps:
a) Coating of the surface of the silicon substrate (1) with a phosphorus-based dopant (2),
b) subsequent heating of the silicon substrate (1) in order to produce a phosphosilicate glass (2) on the surface of the silicon, wherein phosphorus simultaneously diffuses into the silicon as first doping (3),
c) application of a masking (4) to the phosphosilicate glass (2) in such a way that the masking (4) covers the subsequently highly doped regions (5),
d) removal of the phosphosilicate glass (2) in the non-masked regions,
e) removal of the masking (4) from the phosphosilicate glass (2),
f) renewed heating for the further indiffusion of phosphorus from the phosphosilicate glass (2) into the silicon as second doping for the production of the highly doped regions (5),
g) complete removal of the phosphosilicate glass (2) and the oxide from the silicon substrate (1).

2. Method according to Claim 1, **characterized in that** the phosphorus-based dopant (2) is a solution comprising phosphoric acid.

3. Method according to Claim 1 or 2, **characterized in that** the masking (4) is applied by means of a printing technology, preferably by means of a so-called inkjet printing technology.

4. Method according to any of the preceding claims, **characterized in that** a contact grid of a solar cell is produced thereby, wherein the silicon substrate (1) forms the solar cell, wherein the twice doped regions (5) of the silicon are highly doped and therefore have low resistance and constitute a contact region of the solar cell.

5. Method according to any of the preceding claims, **characterized in that** the removal of the phosphosilicate glass (2) in the non-masked regions in accordance with step d) is effected by etching, preferably HF etching.

6. Method according to any of the preceding claims, **characterized in that** it is carried out in a continuous-throughput apparatus, preferably in a horizontal continuous-throughput apparatus.

## Revendications

1. Procédé pour doper sélectivement le silicium d'un substrat (1) en silicium en vue de former une jonction pn dans le silicium, le procédé comportant les étapes suivantes :
a) faire occuper la surface du substrat (1) en silicium par un agent de dopage (2) à base de phosphore,
b) ensuite, chauffer le substrat (1) de silicium pour former à la surface du silicium un verre (2) au silicate phosphoré, du phosphore diffusant en même temps dans le silicium en tant que premier agent de dopage (3),
c) placer un masque (4) sur le verre (2) au silicate phosphoré de telle sorte que le masque (4) couvre les parties (5) qui seront ultérieurement fortement dopées,
d) enlever le verre (2) au silicate phosphore dans les parties non masquées,
e) retirer le masque (4) du verre (2) au silicate phosphoré,
f) chauffer de nouveau pour poursuivre la pénétration du phosphore du verre (2) au silicate phosphoré dans le silicium en tant que deuxième dopage destiné à former les parties (5) fortement dopées et
g) enlever complètement le verre (2) au silicate phosphoré ou l'oxyde du substrat (1) en silicium.

2. Procédé selon la revendication 1, **caractérisé en ce que** l'agent de dopage (2) à base de phosphore est une solution contenant de l'acide phosphorique.

3. Procédé selon les revendications 1 ou 2, **caractérisé en ce que** le masque (4) est appliqué à l'aide d'une technologie d'impression et de préférence d'une technologie d'impression dite à jet d'encre.

4. Procédé selon l'une des revendications précédentes, **caractérisé en ce qu'**il permet de réaliser une grille de contact d'une cellule solaire, le substrat (1) en silicium formant la cellule solaire, les parties (5) dopées deux fois du silicium étant fortement dopées et ainsi à basse résistance ohmique et constituant une partie de contact de la cellule solaire.

5. Procédé selon l'une des revendications précédentes, **caractérisé en ce que** l'enlèvement du verre (2) au silicate phosphoré des parties non masquées de l'étape d) s'effectue par gravure et de préférence par gravure HF.

6. Procédé selon l'une des revendications précédentes, **caractérisé en ce qu'**il est exécuté dans une installation continue et de préférence dans une installation continue horizontale.
